# EUROPEAN PATENT APPLICATION

(11) **EP 2 372 762 A1**
(43) Date of publication of application: **05.10.2011**
(21) Application number: 11250396.6
(22) Date of filing: 29.03.2011
(51) Int. Cl.: H01L 23/473, F28F 3/12

(54) **Compact cold plate configuration**

(30) Priority: 29.03.2010 US 748572
(71) Applicant: Hamilton Sundstrand Corporation, Windsor Locks, CT 06096-1010 (US)
(72) Inventor: Zaffetti, Mark A., Suffield, Connecticut 06078 (US)
(74) Representative: Tomlinson, Kerry John

(57) **Abstract**

A method of communicating fluid through a cold plate (20) includes communicating fluid through an internal header.

## Description

### BACKGROUND

The present disclosure relates to a heat transfer device, and more particularly to a cold plate assembly.

Operation of high speed electronic components such as microprocessors, graphics processors and other modules produces heat. The heat may need to be removed for efficient operation. Heat removal provides, for example, lower operating temperatures, higher operating speeds, greater computing power and higher reliability.

Cold plates are liquid cooled structures which provide a heat transfer function for components mounted thereto. A header which communicates the liquid into the cold plate is typically a separate component attached to the main cold plate. The header may increase the overall geometric envelope.

### SUMMARY

A method of communicating fluid through a cold plate according to an exemplary aspect of the present disclosure includes communicating fluid through an internal header.

### BRIEF DESCRIPTION OF THE DRAWINGS

Various features will become apparent to those skilled in the art from the following detailed description of the disclosed non-limiting embodiment. The drawings that accompany the detailed description can be briefly described as follows:
Figure 1 is a general exploded view of a cold plate assembly and structural panel;
Figure 2 is a perspective view of the cold plate assembly;
Figure 3 is a sectional view along line 3-3 in Figure 2 through an inlet port arrangement with an internal header for the cold plate assembly;
Figure 4 is an expanded view of an outlet port arrangement with an internal header for the cold plate assembly;
Figure 5 is a perspective view of the cold plate assembly and structural panel of Figure 1;
Figure 6 is a sectional view along line 6-6 in Figure 2;
Figure 7 is a partial assembled view of the cold plate assembly at an upper fluid path layer;
Figure 8 is a partial assembled view of the cold plate assembly at middle parting sheet between an upper fluid path layer and a lower fluid path layer;
Figure 9 is a partial assembled view of the cold plate assembly at a lower fluid path layer;
Figure 10 is a partial assembled view of the cold plate assembly at a upper parting sheet level above an upper fluid path layer; and
Figure 11 is a sectional view of another non-limiting embodiment of the internal header along line 6-6 in Figure 2.

### DETAILED DESCRIPTION

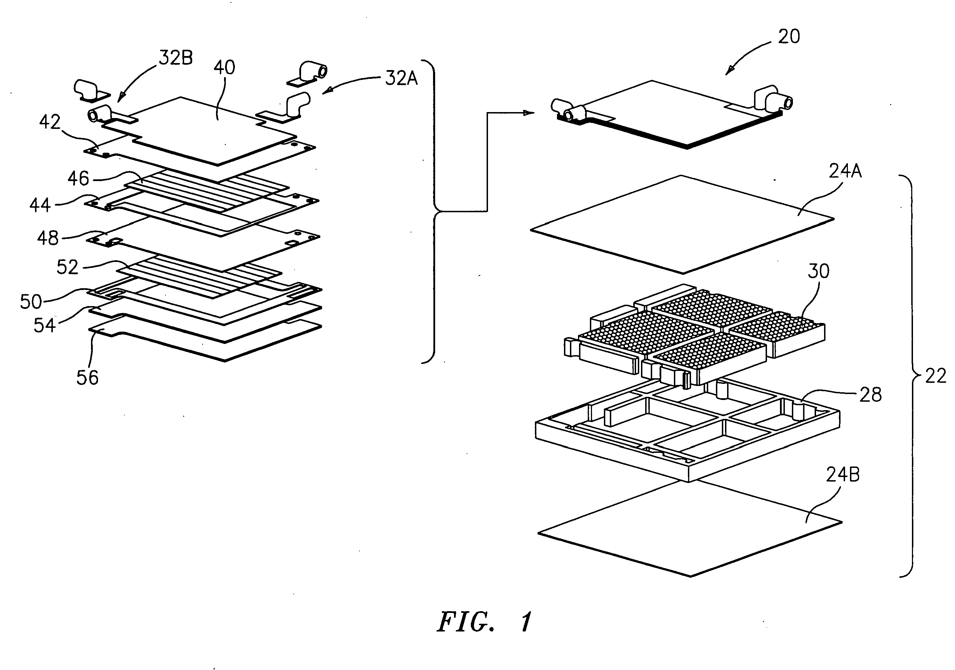

Figure 1 schematically illustrates a cold plate assembly 20. The cold plate assembly 20 is typically mounted to a support panel 22. The support panel 22 may be fabricated from an upper face sheet 24A and a lower face sheet 24B which sandwich a frame 28 and a core 30 such as a honeycomb core therebetween. The support panel 22 is typically assembled with an adhesive to bond the upper face sheet 24A and the lower face sheet 24B to the frame 28 and the core 30. It should be understood that the cold plate assembly 20 may be mounted to various components other than the support panel 22 through fasteners, adhesives or various combinations thereof.

The cold plate assembly 20 generally includes an upper end sheet 40, an upper parting sheet 42, a fluid path B closure bar 44, a fluid path B fin structure 46 (illustrated schematically), a middle parting sheet 48, a fluid path A closure bar 50, a fluid path A fin structure 52 (illustrated schematically), a lower parting sheet 54 and a lower end sheet 56. In one non-limiting embodiment, the upper end sheet 40 may be manufactured of 3004 Aluminum with a nominal thickness of 0.04 inches (1 mm), the upper parting sheet 42 may be manufactured of a braze material, such as CT-23, or a Multiclad alloy with a nominal thickness of 0.016 inches (0.4 mm), the fluid path B closure bar 44 may be manufactured of 6951 Aluminum with a nominal thickness of 0.05 inches (1.3 mm), the fluid path B fin structure 46 may be manufactured of 6951 Aluminum with a nominal thickness of 0.005 inches (0.13 mm), the middle parting sheet 48 may be manufactured of a braze material, such as CT-23, or a Multiclad alloy with a nominal thickness of 0.016 inches (0.4 mm), the fluid path A closure bar 50 may be manufactured of 6951 Aluminum with a nominal thickness of 0.05 inches (1.3 mm), the fluid path A fin structure 52 may be manufactured of 6951 Aluminum with a nominal thickness of 0.005 inches (0.13 mm), the lower parting sheet 54 may be manufactured of a braze material, such as CT-23, or a Multiclad alloy with a nominal thickness of 0.016 inches (0.4 mm) and the lower end sheet 56 may be manufactured of 3004 Aluminum with a nominal thickness of 0.04 inches (1 mm). It should be understood that various materials and nominal thickness may alternatively be utilized.

The parting sheets 42, 48 and 54 include a braze alloy that melts during a brazing process that creates an integral assembly between the sheets 40-56. It should be understood that other bonding or assembly methods may alternatively or additionally be utilized.

Generally, the assembly is brazed together such that: the upper end sheet 40 is brazed to the upper parting sheet 42; the upper parting sheet 42 is brazed to the upper end sheet 40, the path B closure bar 44 and the fluid path B fin structure 46; the fluid path B closure bar 44 is brazed to the upper parting sheet 42 and the middle parting sheet 48; the fluid path B fin structure 46 is brazed to the upper parting sheet 42 and the middle parting sheet 48; the middle parting sheet 48 is brazed to the fluid path B fin structure 46, the fluid path B closure bar 44, the fluid path A fin structure 52 and the fluid path A closure bar 50; the fluid path A closure bar 50 is brazed to the middle parting sheet 48 and to the lower parting sheet 54; the fluid path A fin structure 52 is brazed to the middle parting sheet 48 and to the lower parting sheet 54; and the lower parting sheet 54 is brazed to the fluid path A fin structure 52, the fluid path A closure bar 50 and the lower end sheet 56.

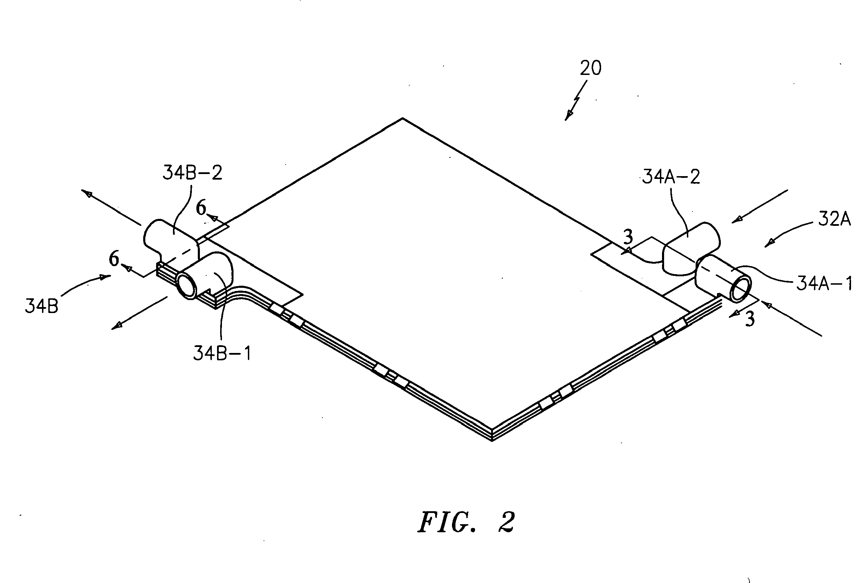

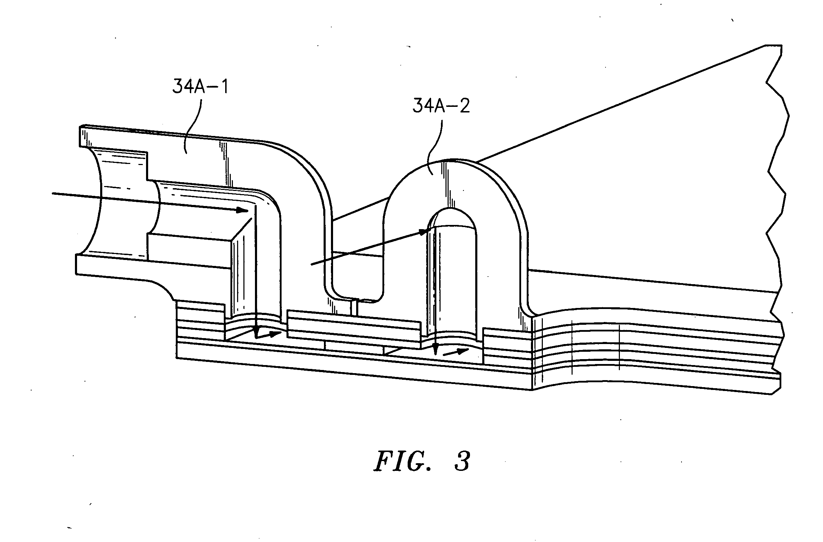

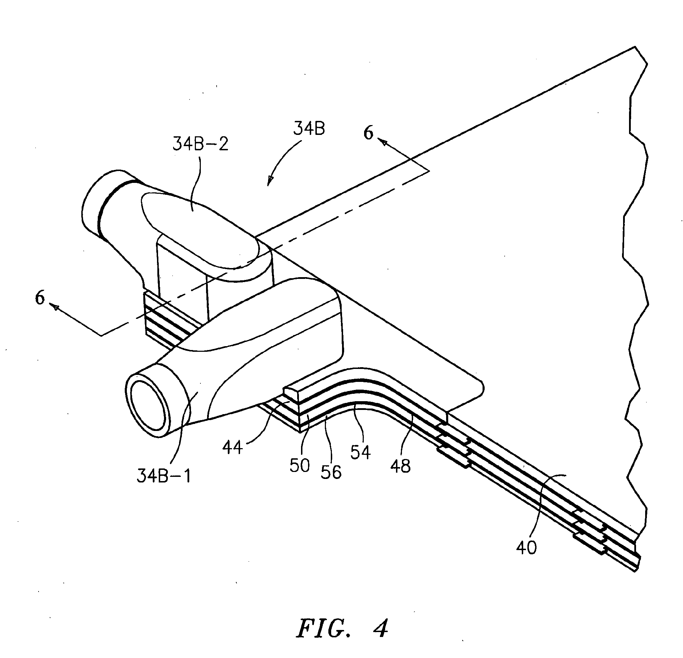

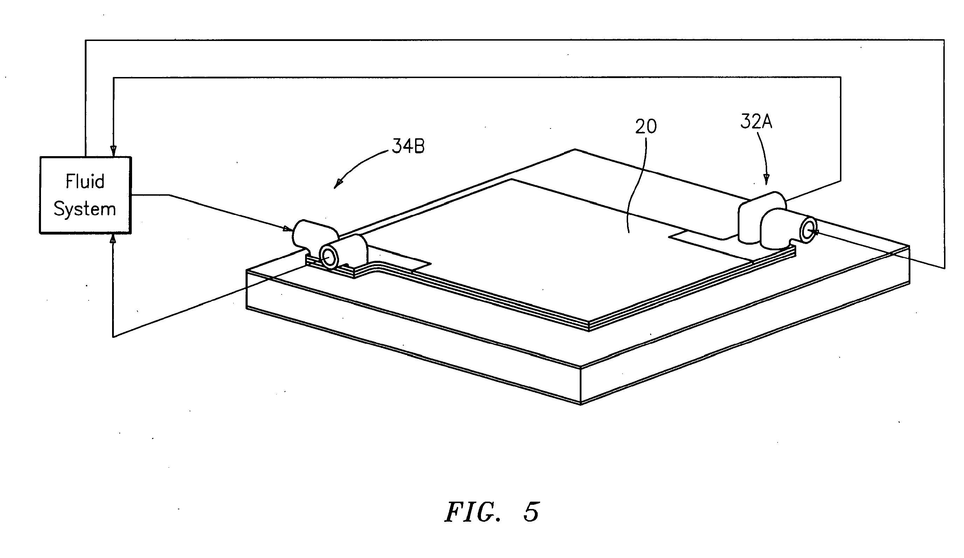

Referring to Figure 2, an inlet header assembly 32A with a first inlet port 34A-1 and a second inlet port 34A-2 communicates fluid into the cold plate assembly 20. The first inlet port 34A-1 and the second inlet port 34A-2 are in fluid communication with a respective first and second fluid layer first through a single layer (Figure 3). Fluid is communicated from the respective fluid layers through an outlet header assembly 34B having a first outlet port 34B-1 and second outlet port 34B-2 (Figure 4) to circulate the fluid through a fluid system 38 as generally understood (illustrated schematically; Figure 5). It should be understood that although a single outlet port in the outlet header assembly 34B will be described in detail herein, at least one port in the inlet header assembly 32A may also be constructed generally in accords therewith but need not be described in specific detail herein.

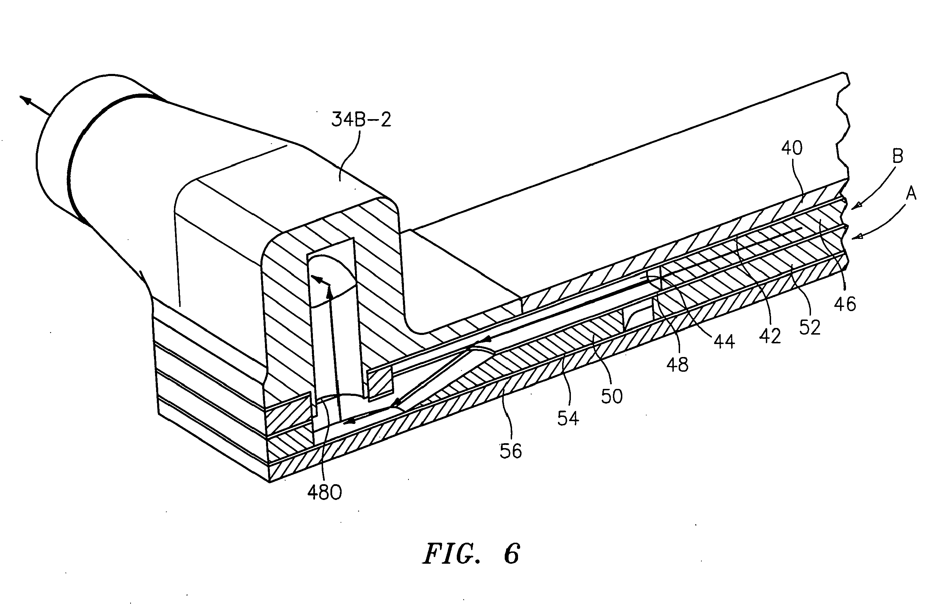

Referring to Figure 6, the second inlet port 34A-2 (Figure 3) communicates with an upper fluid layer path B - through communication of the fluid first through the lower fluid layer - path A - prior to communication out through outlet port 34B-2. That is, communication through the fluid outlet port 34B-2 from the upper fluid path B layer is actually first communicated to the lower fluid path A layer in the fluid path A closure bar 50 but not into the fluid path A fin structure 52 which defines the separate fluid layer. It should be understood that the lower fluid path A layer does not require a similar flow path as the upper fluid path B layer already provides the necessary clearance for internal header flow.

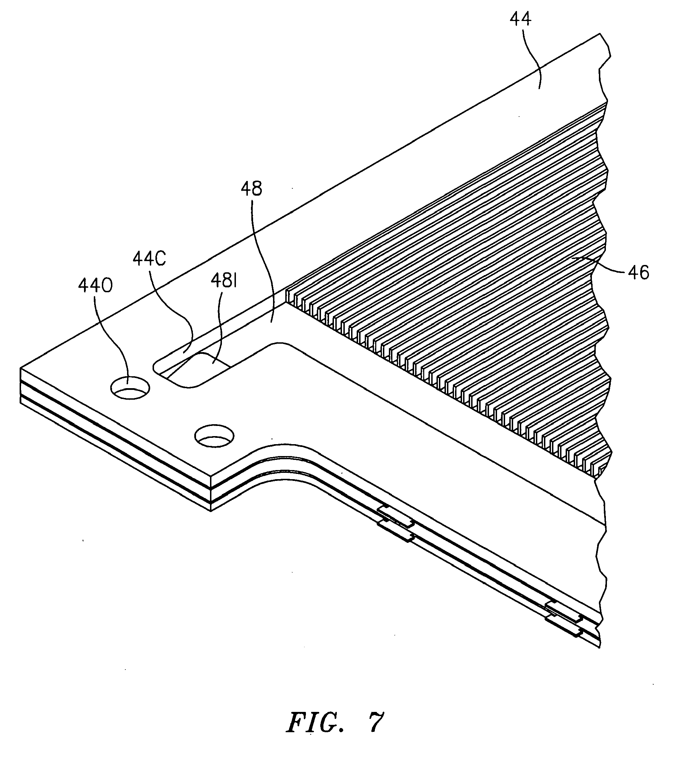

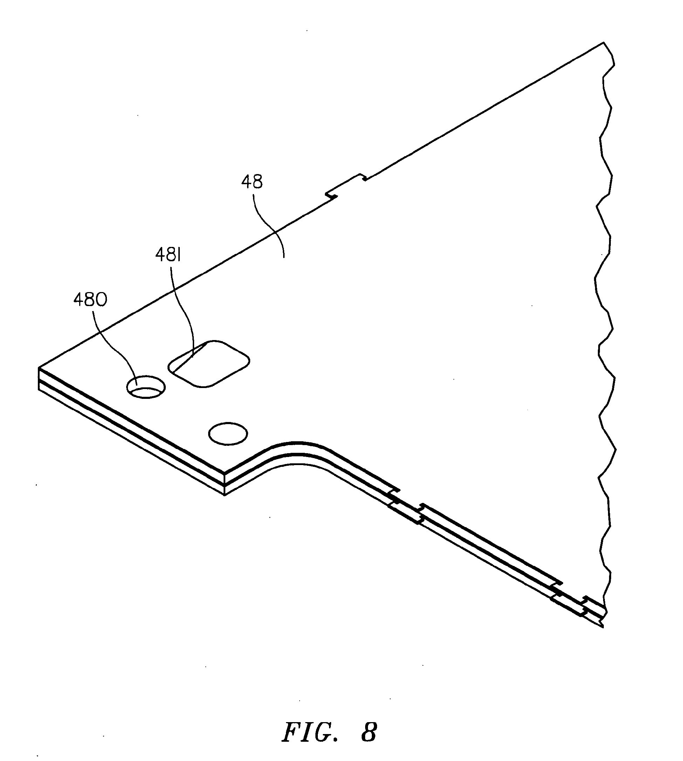

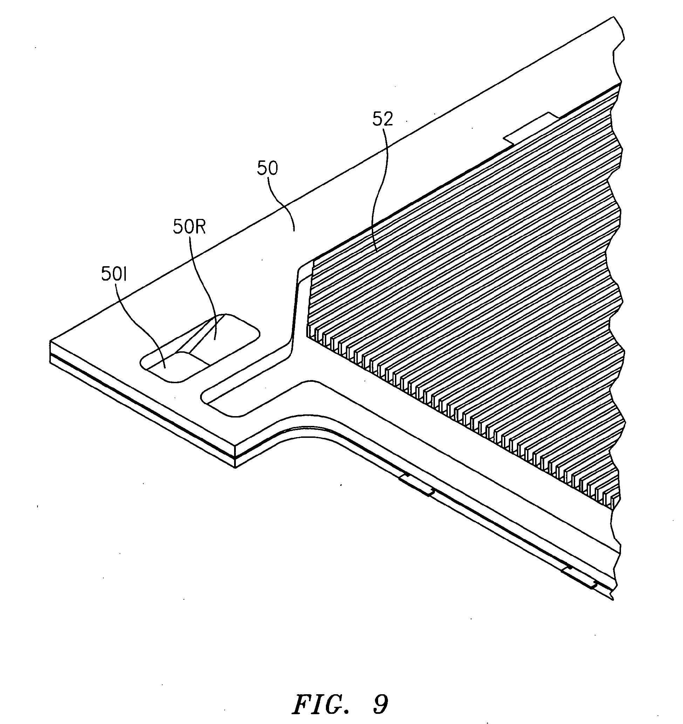

From the upper fluid path B fin structure 46 layer, fluid is communicated through a channel 44C (Figure 7) and through an inlet aperture 481 in the middle parting sheet 48 (Figure 8). Fluid is communicated down a ramp 50R formed in the fluid path A closure bar 50 (Figure 9) to flow adjacent the lower parting sheet 54 at the lower fluid path A fin structure 52 but separated therefrom by the fluid path A closure bar 50. That is, the fluid path A closure bar 50 receives fluid flow from the upper fluid path B layer but does not communicate the fluid into the lower fluid path A fin structure 52.

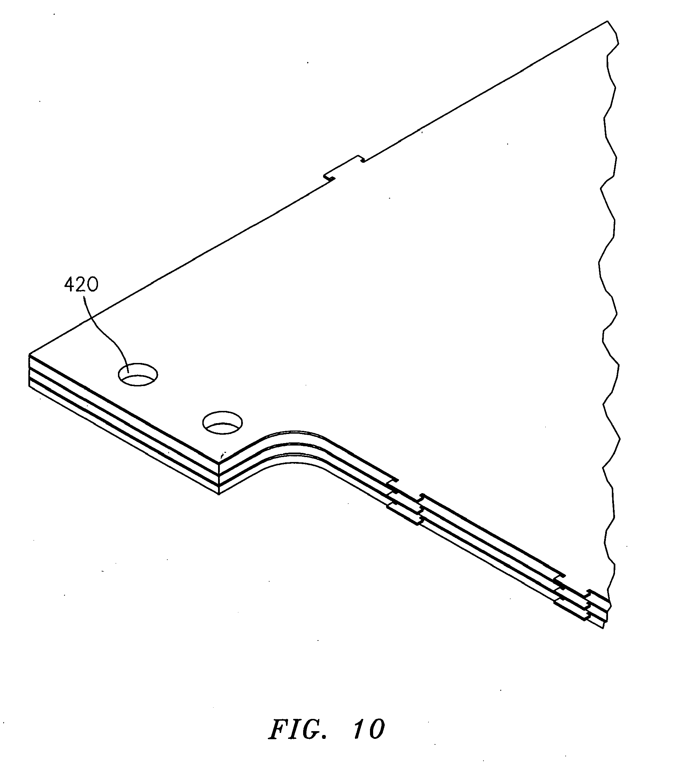

The fluid from the ramp 50R is then communicated upward through a middle parting sheet outlet aperture 480 (Figure 8) in the middle parting sheet 48 then through an aligned outlet 440 in the fluid path B closure bar 44 (Figure 7). The fluid from the aligned outlet 440 is communicated through an aligned aperture 420 through the upper parting sheet 42 (Figure 10) then out through the outlet port 34B-2 which is attached thereto adjacent to the upper end sheet 40.

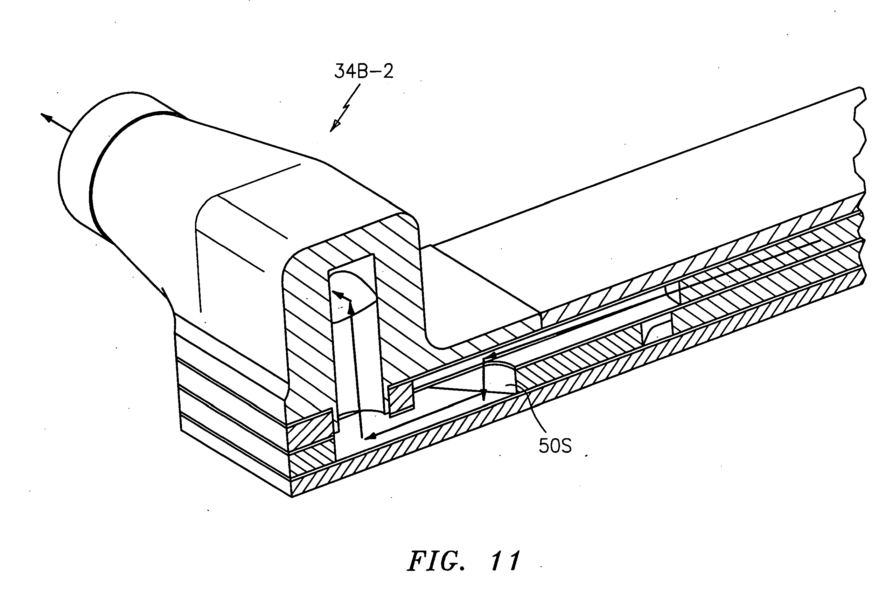

In another non-limiting embodiment, the ramp 50R is replaced with a step 50S. (Figure 11). It should be understood that various other geometric arrangements may alternatively or additionally be provided.

The internal header eliminates the heretofore requirement of an external header through usage of the fluid path A closure bar and the fluid path B closure bar area to communicate fluid from an adjacent level. That is, the fluid is communicated from an upper fluid layer to the lower fluid layer prior to communication out through the outlet port 34B. This arrangement permits the fluid inlet port to be communicated into the same layer that the fluid exits because the ramp has passed the fluid back to the adjacent lower layer. The overall geometric envelope of the cold plate assembly 20 is thereby reduced. Total part count and weight reduction is provided through the elimination of external header components as there is no separate external header assembly for the fluid inlet and outlet. Furthermore, a more structurally sound cold plate assembly results as the external header area is eliminated as a potential area for failure.

It should be understood that like reference numerals identify corresponding or similar elements throughout the several drawings. It should also be understood that although a particular component arrangement is disclosed in the illustrated embodiment, other arrangements will benefit herefrom.

Although particular step sequences are shown, described, and claimed, it should be understood that steps may be performed in any order, separated or combined unless otherwise indicated and will still benefit from the present disclosure.

The foregoing description is exemplary rather than defined by the limitations within. Various non-limiting embodiments are disclosed herein, however, one of ordinary skill in the art would recognize that various modifications and variations in light of the above teachings will fall within the scope of the appended claims. It is therefore to be understood that within the scope of the appended claims, the disclosure may be practiced other than as specifically described. For that reason the appended claims should be studied to determine true scope and content.

## Claims

1. A cold plate assembly comprising:
an internal header with a fluid port, said fluid port being in fluid communication with a fluid path B fin structure in a second layer which contains said fluid path B fin structure through a fluid outlet in a fluid path closure bar in a first layer which contains a fluid path A fin structure.

2. The cold plate assembly as recited in claim 1, wherein said fluid outlet includes a ramped surface.

3. The cold plate assembly as recited in claim 1, wherein said fluid outlet includes a stepped surface.

4. The cold plate assembly as recited in claims 1, 2 or 3, comprising:
an upper end sheet mounted to said port;
an upper parting sheet attached to said upper end sheet, said upper parting sheet including an opening in communication with said port;
a fluid path B closure bar attached to said upper parting sheet, said fluid path B closure bar containing the fluid path B fin structure and a fluid path B channel;
said fluid path closure bar being a fluid path A closure bar containing the fluid path A fin structure, said fluid path A closure bar defining a fluid path A closure bar outlet in communication with said fluid path B channel;
a middle parting sheet attached between said fluid path B closure bar and said fluid path A closure bar, said middle parting sheet including a first opening in communication with said fluid path A closure bar outlet and a second opening in communication with said port.

5. The cold plate assembly as recited in claim 4, wherein said fluid path A closure bar outlet includes a ramped surface.

6. The cold plate assembly as recited in claim 4, wherein said fluid path A closure bar outlet includes a stepped surface.

7. The cold plate assembly as recited in claim 4, 5 or 6, wherein a lower parting sheet is attached to said fluid path A closure bar opposite said middle parting sheet.

8. The cold plate assembly as recited in claim 7, further comprising a lower end sheet attached to said lower parting sheet.

9. A method of communicating fluid through a cold plate comprising:
communicating fluid through an internal header of the cold plate, wherein the internal header communicates fluid through a fluid inlet which passes through a common layer of the cold plate with a fluid outlet.

10. The method as recited in claim 9, further comprising ramping the fluid to a first layer which first receives the fluid from an inlet port from a second layer which receives fluid from the first layer.

11. The method as recited in claim 9, further comprising stepping the fluid to a first layer which first receives the fluid from an inlet port from a second layer which receives fluid from the first layer.
